# EUROPEAN PATENT APPLICATION

(11) **EP 3 486 952 A1**
(43) Date of publication of application: **22.05.2019**
(21) Application number: 18180748.8
(22) Date of filing: 29.06.2018
(51) Int. Cl.: H01L 31/0224, H01L 31/0747

(54) **SOLAR CELL, COMPOSITE ELECTRODE THEREON AND PREPARATION METHOD THEREOF**

(30) Priority: 15.11.2017 CN 201711132784
(71) Applicant: Beijing Juntai Innovation Technology Co., Ltd, 100176 Beijing (CN)
(72) Inventor: YANG, Miao, Beijing, Beijing 100176 (CN); YU, Cao, Beijing, Beijing 100176 (CN); XU, Xixiang, Beijing, Beijing 100176 (CN)
(74) Representative: D'Halleweyn, Nele Veerle Trees Gertrudis

(57) **Abstract**

A preparation method of a composite electrode on a solar cell is provided. The preparation method of the composite electrode includes the following steps of: depositing a metal contact layer on a cell chip; forming an electrode on the metal contact layer to obtain a composite electrode comprising a metal contact layer and an electrode. A composite electrode on the solar cell and the solar cell are also provided.

## Description

This application claims priority to patent application number 201711132784.3 filed in China on November 15, 2017, the entire contents of which are hereby incorporated by reference.

### Technical Field

The present application relates to, but is not limited to, the technical field of solar cells.

### Background

Solar cells have strong power generation performance. The solar cell outputs current through the electrodes on it, while the common electrode extraction manner is to screen print silver paste directly on the cell chip. In order to give consideration to the previous process, the current silver pastes are all low temperature silver pastes.

### Summary

The following is an overview of the subject matter described in detail herein. This summary is not intended to limit the protection scope of the claims.

The inventors of the present application have found that low temperature silver paste often has larger contact resistance, and it is difficult to give consideration to adhesive force.

An embodiment of the present application provides a preparation method of a composite electrode on a solar cell, which is used for promoting the adhesive force of the composite electrode on a cell chip and improving the contact resistance between the composite electrode and the cell chip.

An embodiment of the present application provides a preparing method of a composite electrode on a solar cell, which comprises the following steps of: depositing a metal contact layer on a cell chip; forming an electrode on the metal contact layer to obtain the composite electrode comprising the metal contact layer and the electrode.

In some embodiments, the step of depositing the metal contact layer on the cell chip may include depositing the metal contact layer on a transparent conductive layer of the cell chip.

In some embodiments, the step of depositing the metal contact layer on the transparent conductive layer of the cell chip may include depositing intrinsic layers on the front side and back side of a silicon wafer, respectively; depositing doped layers on the intrinsic layers of the front side and the back side of the silicon wafer respectively; depositing transparent conductive oxide layers on the doped layers on the front side and back side of the silicon wafer respectively; depositing the metal contact layer on the transparent conductive oxide layers of the front side and/or the back side of the silicon wafer.

In some embodiments, the solar cell may be a silicon heterojunction solar cell. The silicon heterojunction solar cell may be silicon heterojunction with intrinsic thin layer solar cell.

In some embodiments, the method may further include removing a portion of the metal contact layer that is not covered by the electrode after forming the electrode on the metal contact layer.

In some embodiments, the step of forming an electrode on the metal contact layer may include forming the electrode on the metal contact layer through a screen printing process.

In some embodiments, the step of removing the portion of the metal contact layer that is not covered by the electrode includes removing the portion of the metal contact layer that is not covered by the electrode using chemical corrosion.

In some embodiments, the method may further include drying the electrode before removing the portion of the metal contact layer that is not covered by the electrode.

In some embodiments, the method may further include carrying out stoving treatment for the electrode before removing the portion of the metal contact layer that is not covered by the electrode.

In some embodiments, the stoving temperature may be from 150°C to 250°C.

In some embodiments, the thickness of the metal contact layer may be from 2 nm to 9 nm.

In some embodiments, the metal contact layer may be selected from any one of silver, nickel, and copper.

In some embodiments, the electrode may include metallic silver and resin.

In some embodiments, the step of depositing the metal contact layer on the cell chip may include depositing the metal contact layer using a physical vapor deposition process.

In some embodiments, the step of depositing the metal contact layer on the cell chip may include depositing the metal contact layer using an electroplating method.

In some embodiments, the method may further include repairing the metal contact layer after depositing the metal contact layer on the cell chip.

In some embodiments, the step of repairing the metal contact layer may include repairing the metal contact layer using an annealing manner.

In some embodiments, the step of repairing the metal contact layer may include repairing the metal contact layer using annealing not exceeding 200°C.

An embodiment of the present application also provides a composite electrode on a solar cell, wherein the composite electrode comprises a metal contact layer and an electrode, wherein the metal contact layer can be set on a cell chip of the solar cell, and the electrode can be set on the metal contact layer.

In some embodiments, the thickness of the metal contact layer may be from 2 nm to 9 nm.

In some embodiments, the metal contact layer may be selected from any one of silver, nickel, and copper.

In some embodiments, the electrode may include metallic silver and resin.

An embodiment of the present application also provides a solar cell, which comprises a cell chip and a composite electrode, wherein the composite electrode can be prepared by the preparation method of the composite electrode on the solar cell in the above embodiment.

An embodiment of the present application also provides a solar cell, which comprises a cell chip and a composite electrode, wherein the composite electrode can be selected from the composite electrodes in the above embodiments.

The preparation method of the composite electrode on the solar cell provided by the embodiment of the present application forms the composite electrode including the electrode and the metal contact layer by depositing the metal contact layer between the cell chip and the electrode, thereby effectively promoting the adhesive force of the composite electrode on the cell chip, simultaneously improving the contact resistance between the composite electrode and the cell chip and enhancing the power generation efficiency of the cell chip.

Other features and advantages of the present application will be set forth in the following description and, in part, will become more apparent from the description, or may be learned by carrying out the present application. The objects and other advantages of the present application may be realized and attained by the structure particularly pointed out in the specification and claims.

### Brief Description of Drawings

Example of the present application will be described in detail below with reference to the accompanying drawings.
FIG. 1 is a flowchart of a preparing method of a composite electrode on a solar cell provided in one example of the present application;
FIG. 2 is a flowchart of a preparing method of a composite electrode on a solar cell provided in another example of the present application;
FIG. 3 is a structural schematic diagram of a solar cell provided in an example of the present application.

In the drawings: 1. cell chip; 2. metal contact layer; 3. electrode.

### Detailed Description

Examples of the present application will be described in detail below in order to make the objects, technical solutions and advantages of the present application be more clearly understood. It should be noted that, if without conflict, the examples and features in the examples of the present application may be combined with each other arbitrarily.

Embodiments of the present application are described in detail below, and examples of the embodiments are shown in the accompanying drawings, wherein the same or similar numerals denote the same or similar elements or elements having the same or similar functions throughout. The embodiments described below with reference to the accompanying drawings are exemplary, and are only used to explain the present application but cannot be construed as limiting the present application.

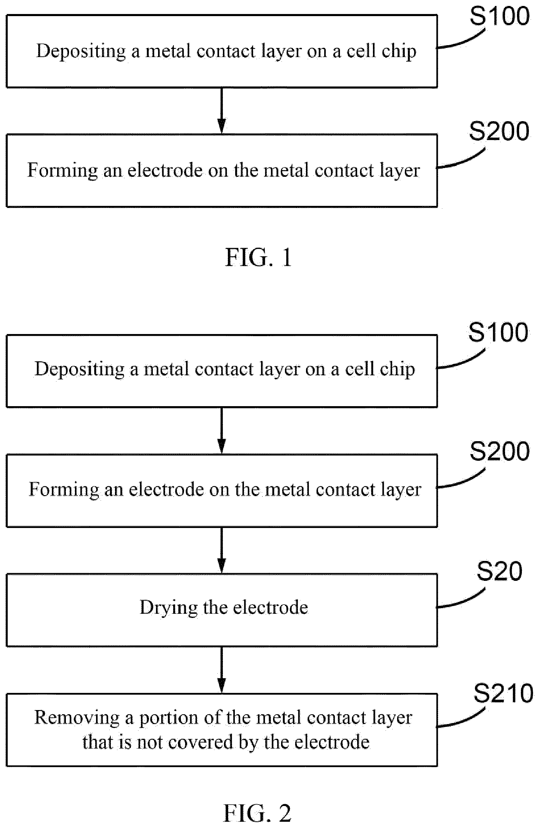

As shown in FIG. 1, an example of the present application provides a preparing method of a composite electrode on a solar cell, which comprises the following steps:
S100. depositing a metal contact layer on a cell chip.
S200. forming an electrode on the metal contact layer.

Thereby a composite electrode comprising the metal contact layer and the electrode is obtained.

Step S100 may include depositing the metal contact layer on a transparent conductive layer on the cell chip.

Step S200 may include forming the electrode on the metal contact layer through a screen printing process.

The silver paste in screen printing can be directly printed on the transparent conductive layer. However, since the transparent conductive layer is usually a metal oxide, the silver paste is not pure silver, which includes silver powder (accounting for more than 90% by mass of the silver paste), resin and solvent, after solvent in the silver paste is evaporated in the subsequent stoving process of the silver paste after screen printing, the adhesive force of the silver paste on the transparent conductive layer is not high, and the silver paste and the transparent conductive layer are not in pure ohmic contact, resulting in larger contact resistance. By depositing a metal contact layer on the transparent conductive layer on the cell chip, the silver paste can be printed on the metal contact layer through a screen printing process to ensure that there is strong bonding force between the metal contact layer and the transparent conductive layer. Besides, the silver paste can be solidified into a whole with the metal contact layer during the screen printing process, thereby enhancing the bonding force between the silver paste and the transparent conductive layer and further ensuring the reliability of electrode molding. The electrodes can also be prepared using copper paste.

In addition, the transparent conductive layer can be an indium tin oxide (ITO) layer, an aluminum doped zinc oxide (AZO) layer, etc., the transparent conductive layer can be a metal oxide layer and the metal contact layer can be a pure metal layer. Therefore, the contact resistance generated at the interface of the metal contact layer after deposition on the transparent conductive layer can be neglected, thus improving the power generation performance of the solar cell.

For solar cells that print electrodes through a screen printing process, the power generation performance of the solar cells can be improved by depositing the metal contact layer.

In an exemplary example, depositing a metal contact layer on a transparent conductive layer on a battery chip may include the steps of:
S101. depositing intrinsic layers on a front side and a back side of a silicon wafer respectively.
S102. depositing doped layers on the intrinsic layers of the front side and back side of the silicon wafer respectively.
S103. depositing transparent conductive oxide layers on the doped layers of the front side and back side of the silicon wafer respectively.
S104. depositing the metal contact layer on the transparent conductive oxide layers of the front side and/or the back side of the silicon wafer.

It can be understood that in order to improve the conductivity of the metal contact layer, the metal contact layer can be selected from any one of silver, nickel and copper.

The electrode may include metallic silver and resin, and the resin has strong adhesive force as an adhesive. In addition, the metal contact layer has a certain porosity. In the process of screen printing, some resin in the silver paste solution will penetrate into the metal contact layer to solidify the metal contact layer and the electrode into a whole, thus ensuring the reliability of the connection between the electrode and the metal contact layer.

In addition, the above steps of depositing the metal contact layer on the transparent conductive layer of the cell chip are only exemplary examples. It should be understood that in step S104, the metal contact layer can be deposited on both the front side and the back side of the transparent conductive layer, and the metal contact layer can also be deposited on either side of the front side and back side of the transparent conductive layer.

Herein the deposited intrinsic layer may be an intrinsic amorphous silicon layer, and the doped layer may be a N-type amorphous silicon layer and a P-type amorphous silicon layer.

As shown in FIG. 2, after step S200, the above method may further include:
S210. removing a portion of the metal contact layer that is not covered by the electrode.

Step S210 may include removing the portion of the metal contact layer that is not covered by the electrode using chemical corrosion.

It can be understood that the electrodes usually occupy only a small part of the area on the transparent conductive layer, while for the metal contact layer, it needs to be deposited on the entire surface of the transparent conductive layer. Therefore, only a part of the metal contact layer has screen printed electrodes. For the metal contact layer on the non-deposited area, it does not need to contact with silver paste, so it will not play a substantial positive role, but will affect the light transmittance of the cell chip and reduce the power generation efficiency of the cell chip. Therefore, in the exemplary example, the portion of the metal contact layer that is not covered by the electrode may be removed using chemical corrosion after screen printing of the silver paste, wherein the portion of the metal contact layer that is not covered by the electrode is the metal contact layer on the non-deposited region.

It should be understood that the removal of the portion of the metal contact layer that is not covered by the electrode is not limited to carry out treatment using chemical corrosion. As long as the method capable of removing the portion of the metal contact layer that is not covered by the electrode can be used for this step.

The thickness of the metal contact layer may be from 2 nm to 9 nm. In an exemplary example, the thickness of the metal contact layer may be 5 nm, while the thickness of the electrode is generally in the micron level. Therefore, the thickness of the metal contact layer and the electrode differ greatly. When the metal contact layer on the non-deposited region is removed by chemical corrosion, only a very thin layer is etched away from the electrode on the deposited region, and for the electrode with a thickness of micron level, the removed layer can be neglected.

Before step S210, the above method may further include:
S20. drying the electrode.

Step S20 may include stoving the electrode. In an exemplary example, stoving the electrodes formed through the screen printing process may be included.

Since resin and solvent are mixed in the silver paste solution, when stoving the screen-printed silver paste after screen printing, the solvent in the silver paste solution can be evaporated, thereby solidifying the resin in the silver paste solution and solidifying the silver paste and the metal contact layer into a whole. Herein, the stoving temperature can be from 150°C to 250°C, for example, the stoving temperature can also be 200°C, at this temperature, the evaporation of the solvent can be accelerated, thus accelerating the solidification speed of the resin in the silver paste without damaging the film layer on the crystalline silicon due to the high temperature.

The metal contact layer can be prepared using a physical vapor deposition (PVD) process, the physical vapor deposition method includes vacuum vapor deposition, sputtering coating, arc plasma plating, ion plating, etc. In an exemplary example, the metal contact layer may be deposited using a magnetron sputtering method in a PVD process, with a sputtering power of 2.5 W/cm², a sputtering pressure of 0.2 Pa, and a sputtering gas of argon of high purity, whereby high-speed deposition of the metal contact layer can be achieved at a lower temperature.

Slight interfacial plasma damage may be caused during sputtering of the metal contact layer, and in order to repair the damage, after step S100, the above method may further include:
S110. repairing the metal contact layer.

Step S110 may include repairing the metal contact layer using a low temperature annealing manner.

In order to avoid damage to the solar cell material caused by excessively high temperatures during annealing, in an exemplary example, the annealing temperature does not exceed 200°C, and may be 150°C. In an exemplary example, the metal contact layer may be repaired using low temperature thermal injection or low temperature light injection annealing manner.

In addition to prepare the metal contact layer using PVD process, the metal contact layer can also be prepared using electroplating method. The specific preparation method can be selected according to actual production and processing conditions, and this example is not limited.

According to the preparation method of the composite electrode on the solar cell provided by the example of the present application, a metal contact layer is deposited between the cell chip and the electrode to form the composite electrode comprising the metal contact layer and the electrode, effectively promoting the adhesive force of the composite electrode on the cell chip, simultaneously improving the contact resistance between the composite electrode and the cell chip, and enhancing the power generation efficiency of the cell chip.

The example of the present application provides a composite electrode on a solar cell, which comprises a metal contact layer and an electrode, wherein the metal contact layer is set on a cell chip of the solar cell, and the electrode is set on the metal contact layer.

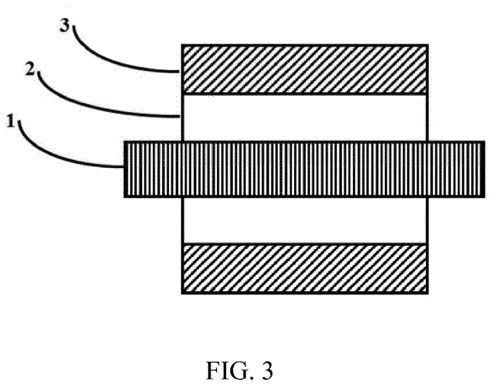

The example of the present application provides a solar cell, the structure is as shown in FIG. 3, and comprises a cell chip 1 and a composite electrode, wherein the composite electrode comprises a metal contact layer 2 and an electrode 3, the metal contact layer 2 is set on the cell chip of the solar cell, and the electrode 3 is set on the metal contact layer 2.

In an exemplary example, the cell chip includes a transparent conductive layer, a P-type doped layer, an intrinsic layer, a silicon wafer, an intrinsic layer, a N-type doped layer, and a transparent conductive layer that are sequentially stacked. Metal contact layers are respectively set on the transparent conductive layer and electrodes are respectively set on the metal contact layers.

In an exemplary example, the thickness of the metal contact layer is from 2 nm to 9 nm. The metal contact layer is selected from any one of silver, nickel and copper; the electrode includes metallic silver and resin.

In an exemplary example, the intrinsic layer may be an intrinsic amorphous silicon layer; the N-type doped layer may be a N-type amorphous silicon layer, the P-type doped layer may be a P-type amorphous silicon layer, the doped layer on the intrinsic layer of the first side of the silicon wafer may be a N-type amorphous silicon layer, and the doped layer on the intrinsic layer of the second side of the silicon wafer is a P-type amorphous silicon layer, or the doped layer on the intrinsic layer of the first side of the silicon wafer may be a P-type amorphous silicon layer, and the doped layer on the intrinsic layer of the second side of the silicon wafer is an N-type amorphous silicon layer; and the transparent conductive layer may be a transparent conductive oxide layer.

It should be understood that a metal contact layer may also be deposited on either side of the front side and back side of the transparent conductive layer.

According to the composite electrode on the solar cell and the solar cell provided by the example of the present application, the metal contact layer and the electrode are closely connected, and are connected with the cell chip through the metal contact layer, effectively promoting the adhesive force of the composite electrode on the cell chip, simultaneously improving the contact resistance between the composite electrode and the cell chip, and enhancing the power generation efficiency of the cell chip.

This disclosure is illustrative of the principles of examples of the present application and is not intended to limit the application in any form or substance, or to limit the application to particular embodiments. It will be apparent to those skilled in the art that variations, changes, modifications, variations, and the like may be made to the elements, methods, and systems of the technical solutions of the examples of the present application without departing from the principles, spirit, and scope of the examples, technical solutions of the present application as defined in the claims. Embodiments of such variations, changes, modifications, and variations are all included within equivalent examples of the present application, which are all included within the scope as defined by the claims of the present application. Although the examples of the present application may be embodied in many different forms, what is described in detail herein are merely some embodiments of the present application. Furthermore, examples of the present application include any possible combination of some or all of the various embodiments described herein, and are also included within the scope as defined by the claims of the present application. All patents, patent applications, and other cited materials mentioned in this application or anywhere in any cited patent, cited patent application, or other cited material are hereby incorporated by reference in their entirety.

The above disclosure is intended to be illustrative and not exhaustive. Many variations and alternatives will be suggested to those skilled in the art. All such alternatives and variations are intended to be included within the scope of the present claims, wherein the term "including" means "including, but not limited to".

A description of alternative embodiments of the present application has been completed herein. Those skilled in the art will recognize other equivalent changes to the embodiments described herein that are also encompassed by the claims appended hereto.

## Claims

1. A preparing method of a composite electrode on a solar cell, comprising the following steps of:
depositing a metal contact layer on a cell chip; and
forming an electrode on the metal contact layer to obtain the composite electrode comprising the metal contact layer and the electrode.

2. The preparing method of a composite electrode on a solar cell according to claim 1, wherein the step of depositing the metal contact layer on the cell chip comprises:
depositing the metal contact layer on a transparent conductive layer of the cell chip.

3. The preparing method of a composite electrode on a solar cell according to claim 2, wherein the step of depositing the metal contact layer on the transparent conductive layer of the cell chip comprises:
depositing intrinsic layers on the front side and the back side of a silicon wafer respectively;
depositing doped layers on the intrinsic layers on the front side and the back side of the silicon wafer respectively;
depositing transparent conductive oxide layers on the doped layers on the front side and back side of the silicon wafer respectively; and
depositing the metal contact layer on the transparent conductive oxide layers on the front side and/or the back side of the silicon wafer.

4. The preparing method of a composite electrode on a solar cell according to any one of claims 1 to 3, wherein the solar cell is a silicon heterojunction solar cell.

5. The preparing method of a composite electrode on a solar cell according to any one of claims 1 to 4, further comprising:
after forming the electrode on the metal contact layer, removing a portion of the metal contact layer that is not covered by the electrode.

6. The preparing method of a composite electrode on a solar cell according to claim 5, wherein,
the step of forming an electrode on the metal contact layer comprises forming the electrode on the metal contact layer through a screen printing process; and/or,
the step of removing the portion of the metal contact layer that is not covered by the electrode comprises removing the portion of the metal contact layer that is not covered by the electrode using chemical corrosion.

7. The preparing method of a composite electrode on a solar cell according to claim 6, further comprising:
drying the electrode before removing the portion of the metal contact layer that is not covered by the electrode; or
carrying out stoving treatment for the electrode before removing the portion of the metal contact layer that is not covered by the electrode, wherein the stoving temperature is from 150°C to 250°C.

8. The preparing method of a composite electrode on a solar cell according to any one of claims 1 to 7, wherein,
the thickness value of the metal contact layer is from 2 nm to 9 nm; and/or,
the metal contact layer is selected from any one of silver, nickel and copper.

9. The preparing method of a composite electrode on a solar cell according to any one of claims 1 to 8, wherein the electrode comprises metallic silver and resin.

10. The preparing method of a composite electrode on a solar cell according to any one of claims 1 to 9, wherein the step of depositing the metal contact layer on the cell chip comprises:
depositing the metal contact layer using a physical vapor deposition process or an electroplating method.

11. The preparing method of a composite electrode on a solar cell according to any one of claims 1 to 10, further comprising:
after depositing the metal contact layer on the cell chip, repairing the metal contact layer.

12. The preparing method of a composite electrode on a solar cell according to claim 11, wherein,
the metal contact layer is repaired using an annealing manner;
preferably, the metal contact layer is repaired using annealing not exceeding 200°C.

13. A composite electrode on a solar cell, the composite electrode comprising a metal contact layer and an electrode, the metal contact layer being set on a cell chip of the solar cell, and the electrode being set on the metal contact layer.

14. A composite electrode on a solar cell according to claim 13, wherein the thickness of the metal contact layer is from 2 nm to 9 nm; alternatively, the metal contact layer is selected from any one of silver, nickel and copper; alternatively, the electrode includes metallic silver and resin.

15. A solar cell, comprising a cell chip and a composite electrode, wherein the composite electrode is prepared by the preparation method of a composite electrode on a solar cell according to any one of claims 1 to 12 or is selected from the composite electrode according to any one of claims 13 to 14.
